# EUROPEAN PATENT APPLICATION

(11) **EP 4 580 354 A1**
(43) Date of publication of application: **02.07.2025**
(21) Application number: 24220453.5
(22) Date of filing: 17.12.2024
(51) Int. Cl.: H10H 29/24

(54) **LIGHT-EMITTING DEVICE AND LIGHT-EMITTING UNIT**

(30) Priority: 22.12.2023 JP 2023216737; 12.07.2024 JP 2024112263
(71) Applicant: NICHIA CORPORATION, Tokushima 774-8601 (JP)
(72) Inventor: NISHIMORI, Takehiro, Anan-shi, Tokushima, 774-8601 (JP)
(74) Representative: Betten & Resch

(57) **Abstract**

A light-emitting device includes a support; a first electrically conductive part, a second electrically-conductive part, and a third electrically conductive part disposed apart from one another on the support; a first light-emitting element disposed on the first electrically-conductive part; and an integrated circuit electrically connected to the first light-emitting element. At least a portion of the first electrically-conductive part is located between the second electrically-conductive part and the third electrically-conductive part in a first direction. The integrated circuit and the first light-emitting element are arranged side by side in a second direction orthogonal to the first direction. A maximum length of the integrated circuit in the second direction is smaller than a maximum length of the integrated circuit in the first direction.

## Description

### BACKGROUND

The present disclosure relates to a light-emitting device and a light-emitting unit.

For example, Japanese Patent Publication No. 2016-206382 describes a light-emitting device including a support, a light-emitting element disposed on the support, and an integrated circuit disposed on the support.

### SUMMARY

It is an object of one embodiment of the present disclosure to provide a light-emitting device that is reduced in size.

A light-emitting device according to one embodiment of the present disclosure includes a support on which a first electrically-conductive part, a second electrically-conductive part, and a third electrically-conductive part are disposed apart from one another; a first light-emitting element disposed on the first electrically-conductive part; and an integrated circuit electrically connected to the first light-emitting element, wherein at least a portion of the first electrically-conductive part is located between the second electrically-conductive part and the third electrically-conductive part in a first direction, the integrated circuit and the first light-emitting element are arranged side by side in a second direction orthogonal to the first direction, and a maximum length of the integrated circuit in the second direction is smaller than a maximum length of the integrated circuit in the first direction.

### BRIEF DESCRIPTION OF THE DRAWINGS

FIG. 1 is a first schematic top view of a light-emitting device according to a first embodiment;
FIG. 2 is a second schematic top view of the light-emitting device according to the first embodiment;
FIG. 3 is a third schematic top view of the light-emitting device according to the first embodiment;
FIG. 4 is a schematic top view of a light-emitting device according to a second embodiment;
FIG. 5 is a schematic top view of a light-emitting device according to a third embodiment;
FIG. 6 is a schematic perspective view of the light-emitting device taken through line VI-VI of FIG. 5;
FIG. 7 is a schematic cross-sectional view taken through line VII-VII of FIG. 5;
FIG. 8 is a schematic diagram illustrating a system configuration of a light-emitting unit according to a fourth embodiment;
FIG. 9 is a schematic top view of a light-emitting device according to a fifth embodiment;
FIG. 10 is a schematic top view of a light-emitting unit according to a first example of a sixth embodiment;
FIG. 11 is a schematic cross-sectional view taken through line XI-XI of FIG. 10;
FIG. 12 is a schematic top view of a light-emitting unit according to a second example of the sixth embodiment; and
FIG. 13 is a schematic cross-sectional view taken through line XIII-XIII of FIG. 12.

### DETAILED DESCRIPTION

Embodiments will be described below with reference to the accompanying drawings. The drawings are intended to schematically illustrate the embodiments, and thus the scales, distances, positional relationships, and the like of members may be exaggerated, or illustration of portions of members may be omitted.

In the following description, components having substantially the same function are denoted by the same reference numeral and a description thereof may be omitted. Terms indicating specific directions or positions (for example, "upper," "upward," "lower," "downward," and other terms related to these terms) may be used. These terms are merely used to facilitate understanding of relative directions or relative positions in the referenced drawings. As long as the relative directions or the relative positions designated by the terms "upper," "lower," and the like designate the same directions or positions in the referenced drawings, drawings other than those provided in the present disclosure, actual products, and the like do not have to have the same arrangement as that shown in the referenced drawings. The term "parallel" in the present specification indicates not only the case in which two straight lines, sides, surfaces, or the like do not intersect even when extended but also the case in which two straight lines, sides, surfaces, or the like intersect to form an angle within the range of 10° or less. The positional relationship represented as "on" in the present specification includes both the case in which components are in contact with each other and the case in which a component is not in contact with but is located above another component.

In the present specification, to indicate directions, an orthogonal coordinate system having a D1 axis, a D2 axis, and a D3 axis is used. The D1 axis, the D2 axis, and the D3 axis are orthogonal to one another. A direction along the D1 axis is referred to as a first direction D1, a direction along the D2 axis is referred to as a second direction D2, and a direction along the D3 axis is referred to as a third direction D3 (an up-down direction). A direction indicated by the arrow of the D1 axis is referred to as a rightward direction, and a direction opposite to the rightward direction is referred to a leftward direction. A direction indicated by the arrow of the D2 axis is referred to as a forward direction, and a direction opposite to the forward direction is referred to a rearward direction. A direction indicated by the arrow of the D3 axis is referred to as an upward direction, and a direction opposite to the upward direction is referred to a downward direction. The phrase "in a top view" refers to viewing an object from above. A top view is synonymous with a plan view.

### [First Embodiment]

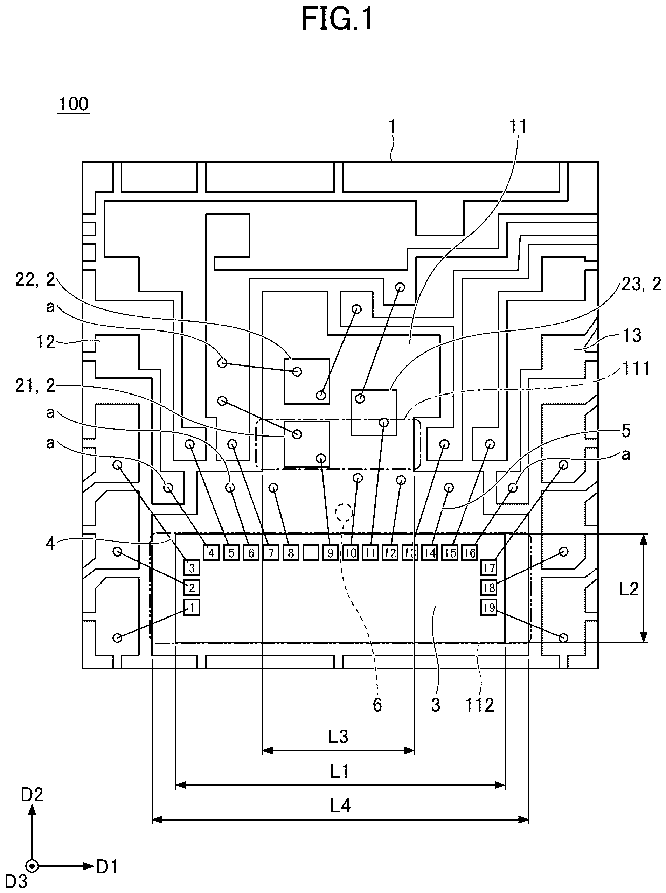

A light-emitting device according to a first embodiment will be described with reference to FIG. 1 to FIG. 3. FIG. 1 to FIG. 3 are schematic top views illustrating an example of a light-emitting device 100 according to the first embodiment.

As illustrated in FIG. 1 to FIG. 3, the light-emitting device 100 includes a support 1 on which a first electrically-conductive part 11, a second electrically-conductive part 12, and a third electrically-conductive part 13 are disposed apart from one another, a first light-emitting element 21 disposed on the first electrically-conductive part 11, and an integrated circuit 3 electrically connected to the first light-emitting element 21. In the example illustrated in FIG. 1 to FIG. 3, the light-emitting device 100 further includes a plurality of first wires 4 connected to the integrated circuit 3, a second light-emitting element 22, and a third light-emitting element 23. Further, the plurality of first wires 4 include a second wire 5 that connects the integrated circuit 3 and the first electrically-conductive part 11. Further, the support 1 has a via 6 electrically connected to the first electrically-conductive part 11. The light-emitting device 100 may include wires other than the plurality of first wires 4, may include electrically-conductive parts other than the first electrically-conductive part 11, the second electrically-conductive part 12, and the third electrically-conductive part 13, and may have a via other than the via 6. A connection part a is a portion that connects a wire such as one of the plurality of first wires 4 to an electrically-conductive part such as the first electrically-conductive part 11, the second electrically-conductive part 12, or the third electrically-conductive part.

In the present embodiment, at least a portion of the first electrically-conductive part 11 is located between the second electrically-conductive part 12 and the third electrically-conductive part 13 in the first direction D1. The integrated circuit 3 and the first light-emitting element 21 are arranged side by side in the second direction D2 orthogonal to the first direction D1. A maximum length L2 of the integrated circuit 3 in the second direction D2 is smaller than a maximum length L1 of the integrated circuit 3 in the first direction D1. With this configuration, in the present embodiment, the light-emitting device 100 can be reduced in size in the second direction D2. Accordingly, the light-emitting device 100 that is reduced in size can be provided. From the viewpoint of reducing the size of the light-emitting device 100, the maximum length L2 of the integrated circuit 3 in the second direction D2 is preferably smaller than half of the maximum length L1 of the integrated circuit 3 in the first direction D1. Further, the first light-emitting element 21 is preferably interposed between the second electrically-conductive part 12 and the third electrically-conductive part 13 in the first direction D1. With this configuration, the first light-emitting element 21, the second electrically-conductive part 12, and the third electrically-conductive part 13 can be arranged at a high density, thereby facilitating a reduction in the size of the light-emitting device 100. Further, it is preferable that the second electrically-conductive part 12 and the third electrically-conductive part 13 do not overlap the first light-emitting element 21 in the second direction D2. This makes it easy to reduce the size of the light-emitting device 100 in the second direction D2.

In the light-emitting device 100 illustrated in FIG. 1 to FIG. 3, the integrated circuit 3 is located on the first electrically-conductive part 11. Therefore, as compared to when the integrated circuit 3 is located away from the first electrically-conductive part 11, a gap between the integrated circuit 3 and the first electrically-conductive part 11 can be eliminated. Because there is no gap between the integrated circuit 3 and the first electrically-conductive part 11, the size of the light-emitting device 100 illustrated in FIG. 1 to FIG. 3 can be reduced.

In the light-emitting device 100 illustrated in FIG. 1, a maximum length L3 of a first portion 111, including a region overlapping the first light-emitting element 21, of the first electrically-conductive part 11 in the first direction D1 is smaller than a maximum length L4 of a second portion 112, including a region overlapping the integrated circuit 3, of the first electrically-conductive part 11 in the first direction D1. With this configuration, in the light-emitting device 100 illustrated in FIG. 1, the first portion 111, including the region overlapping the first light-emitting element 21, of the first electrically-conductive part 11 can be located inward of the second portion 112, including the region overlapping the integrated circuit 3, of the first electrically-conductive part 11 in the first direction D1. Thus, the light-emitting device 100 can be reduced in size in the first direction D1. In FIG. 1, a dash-dot line indicating the first portion 111 and a two-dot dash line indicating the second portion 112 are illustrated for the sake of description.

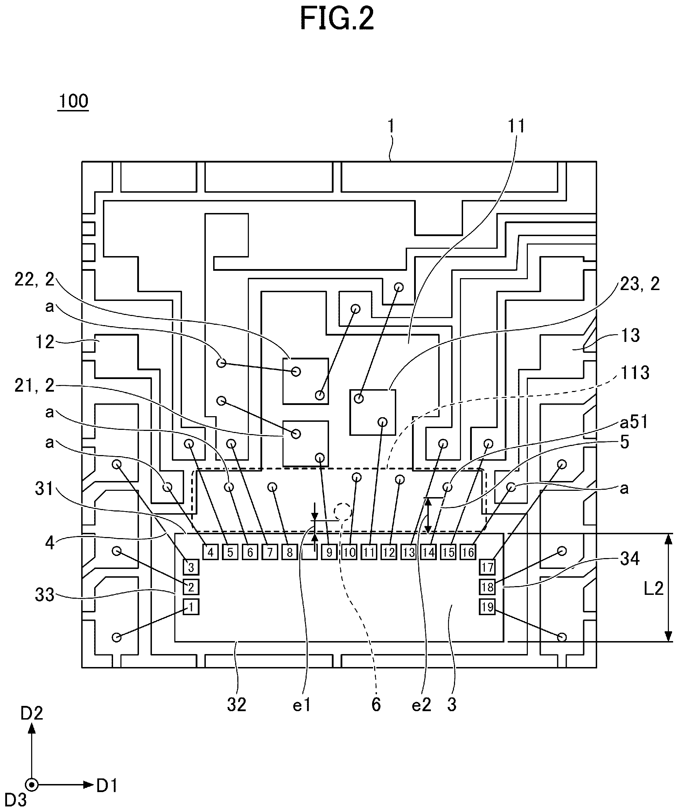

In the light-emitting device 100 illustrated in FIG. 2, the integrated circuit 3 has a first outer edge 31 facing the first light-emitting element 21 in a top view, and a second outer edge 32 located opposite to the first outer edge 31 in a top view. Further, the integrated circuit 3 has a third outer edge 33 connected to each of the first outer edge 31 and the second outer edge 32 in a top view, and a fourth outer edge 34 located opposite to the third outer edge 33 in a top view. In the light-emitting device 100 illustrated in FIG. 2, the plurality of first wires 4 are located away from the second outer edge 32 in a top view. With this configuration, in the light-emitting device 100 illustrated in FIG. 2, none of the first wires 4 is located at a position straddling the second outer edge 32, thereby facilitating a reduction in the size of the light-emitting device 100 in the second direction D2.

In the light-emitting device 100 illustrated in FIG. 2, the quantity of first wires 4 overlapping the first outer edge 31 in a top view is greater than the sum of the quantity of first wires 4 overlapping the third outer edge 33 in a top view and the quantity of first wires 4 overlapping the fourth outer edge 34 in a top view. With this configuration, in the light-emitting device 100 illustrated in FIG. 1 to FIG. 3, it becomes easier to reduce the maximum length L2 of the integrated circuit 3 in the second direction D2, and thus the size of the light-emitting device 100 in the second direction D2 can be easily reduced.

In the light-emitting device 100 illustrated in FIG. 2, the second wire 5 is connected to a third portion 113 of the first electrically-conductive part 11. The third portion 113 is located between the first light-emitting element 21 and the integrated circuit 3 in the second direction D2. The longer the second wire 5 is, the more easily the second wire 5 is disconnected. By connecting the second wire 5 to the third portion 113, the length of the second wire can be reduced as compared to when the second wire 5 is connected to the side of the first electrically-conductive part 11 opposite to the side where the integrated circuit 3 is located with respect to the first light-emitting element 21. Accordingly, in the light-emitting device 100 illustrated in FIG. 2, the second wire 5 is less likely to be disconnected. In FIG. 2, a dashed line indicating the third portion 113 is illustrated for the sake of description.

In the light-emitting device 100 illustrated in FIG. 1 to FIG. 3, the via 6 is located between the first light-emitting element 21 and the integrated circuit 3 in the second direction D2. With this configuration, heat generated from each of the first light-emitting element 21 and the integrated circuit 3 can be released through the via 6 to an external substrate or the like on which the support 1 is disposed. As a result, in the light-emitting device 100 illustrated in FIG. 1 to FIG. 3, the heat dissipation of the light-emitting device 100 can be improved.

In the light-emitting device 100 illustrated in FIG. 2, a minimum distance e1 between the integrated circuit 3 and the via 6 in the second direction D2 is smaller than a minimum distance e2 between a connection part a51 connecting the second wire 5 to the first electrically-conductive part 11 and the integrated circuit 3 in the second direction D2. With this configuration, the integrated circuit 3 and the via 6 are located close to each other in a plan view, and thus heat generated from the integrated circuit 3 can be easily released through the via 6 to an external substrate or the like on which the support 1 is disposed.

In the light-emitting device 100 illustrated in FIG. 1 to FIG. 3, the peak emission wavelength of the first light-emitting element 21 is 430 nm or more and 480 nm or less. Further, the peak emission wavelength of the second light-emitting element 22 is 500 nm or more and 580 nm or less. Further, the peak emission wavelength of the third light-emitting element 23 is 600 nm or more and 780 nm or less. The light-emitting device 100 can easily emit white light by including the first light-emitting element 21, the second light-emitting element 22, and the third light-emitting element 23.

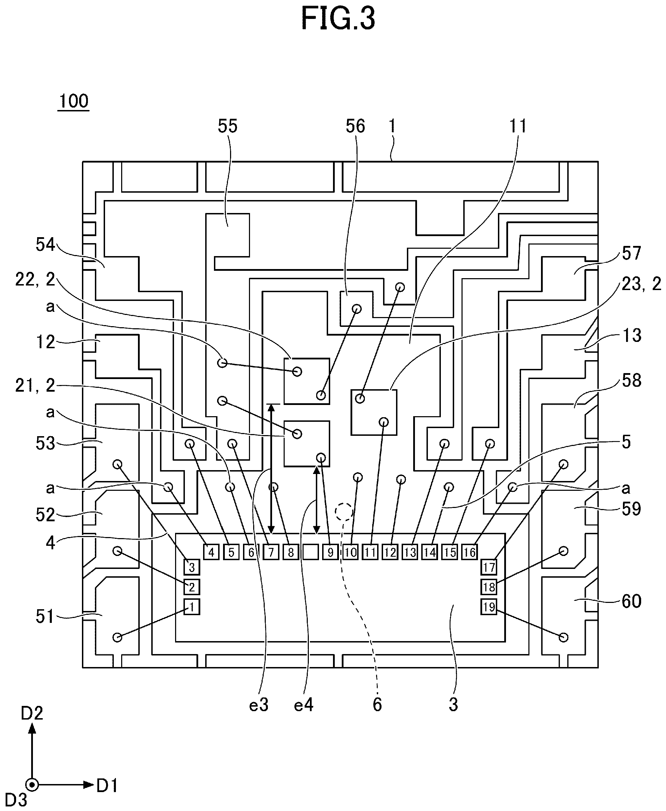

In the light-emitting device 100 illustrated in FIG. 3, a minimum distance e3 between the second light-emitting element 22 and the integrated circuit 3 in the second direction D2 is greater than a minimum distance e4 between the first light-emitting element 21 and the integrated circuit 3 in the second direction D2. In general, in a case in which white light is emitted from a light-emitting element that emits blue light, a light-emitting element that emits green light, and a light-emitting element that emits red light, the light-emitting element that emits green light is required to have higher luminance than the light-emitting element that emits blue light. Therefore, a current value for driving the light-emitting element that emits green light is higher than a current value for driving the light-emitting element that emits blue light, and thus the temperature of the light-emitting element that emits green light is more likely to increase due to heat generation than in the case of the light-emitting element that emits blue light. Further, because the integrated circuit generates heat, the temperature of a light-emitting element disposed closer to the integrated circuit is more likely to increase due to heat transferred from the integrated circuit. If a junction temperature is reached due to an increase in temperature, the light-emitting element would be damaged. Conversely, in the light-emitting device 100 illustrated in FIG. 3, the minimum distance e3 between the second light-emitting element 22 and the integrated circuit 3 in the second direction D2 is greater than the minimum distance e4 between the first light-emitting element 21 and the integrated circuit 3 in the second direction D2. Thus, heat transfers from the integrated circuit 3 to the second light-emitting element 22 can be suppressed. Accordingly, in the light-emitting device 100 illustrated in FIG. 3, an increase in the temperature of the second light-emitting element 22 can be suppressed, and damage to the second light-emitting element 22 can be suppressed.

Each component constituting the light-emitting device 100 will be described in detail below.

### (Support 1)

The support 1 is a member on which a light-emitting element 2 is mounted. The light-emitting element 2 is mounted on the upper surface of the support 1. The light-emitting element 2 is bonded to the upper surface of the support 1 by a bonding member such as a resin, solder, or electrically-conductive paste. In the example illustrated in FIG. 3, the light-emitting device 100 includes electrically-conductive parts 51 to 60 in addition to the first electrically-conductive part 11, the second electrically-conductive part 12, and the third electrically-conductive part 13. The electrically-conductive part 51 is an electrically-conductive part located to the left of the integrated circuit 3 in a top view and having a substantially rectangular shape with the longer side being in the second direction D2. The electrically-conductive part 52 is an electrically-conductive part located in front of the electrically-conductive part 51 in a top view and having a substantially rectangular shape with the longer side being in the second direction D2. The electrically-conductive part 53 is an electrically-conductive part located in front of the electrically-conductive part 52 and having a substantially rectangular shape with the longer side being in the second direction D2. The electrically-conductive part 54 is an electrically-conductive part having a shape extending forward from the left of the first electrically-conductive part 11 and extending rightward from a front end portion of the support 1 in a top view. The electrically-conductive part 55 is an electrically-conductive part located inward of the electrically-conductive part 54 and having a shape extending forward from the left of the first electrically-conductive part 11 and extending rightward from a front end portion of the support 1 in a top view. The electrically-conductive part 56 is an electrically-conductive part having a shape extending to the right from the front of the first electrically-conductive part 11 and then branching to the front-right and to the rear in a top view. The electrically-conductive part 57 is an electrically-conductive part having a shape extending forward from the right of the first electrically-conductive part 11 in a top view. The electrically-conductive part 58 is an electrically-conductive part located to the right of the first electrically-conductive part 11 and having a substantially rectangular shape with the longer side being in the second direction D2. The electrically-conductive part 59 is an electrically-conductive part located rearward of the electrically-conductive part 58 and having a substantially rectangular shape with the longer side being in the second direction D2. The electrically-conductive part 60 is an electrically-conductive part located rearward of the electrically-conductive part 59 and having a substantially rectangular shape with the longer side being in the second direction D2.

A wiring board including a substrate and wiring may be used for the support 1. The substrate can be composed of a resin, a ceramic, glass, or the like. A publicly-known material such as a thermosetting resin or a thermoplastic resin can be used as the resin. Examples of the ceramic include aluminum oxide, aluminum nitride, zirconium oxide, zirconium nitride, titanium oxide, titanium nitride, and a mixture of any of the above. The wiring can be formed of copper, iron, nickel, tungsten, chromium, aluminum, silver, gold, titanium, palladium, rhodium, or an alloy of any of these metals. A single layer or a multilayer of such a metal or an alloy may be used.

For each of the first electrically-conductive part 11, the second electrically-conductive part 12, and the third electrically-conductive part 13, a lead having electrical conductivity and functioning as an electrode for supplying electric power to the light-emitting element 2 can be used. Examples of a base material of the lead include metals such as copper, aluminum, gold, silver, iron, nickel, alloys of these metals, phosphor bronze, and copper containing iron, and the like. A single layer or a multilayer structure (such as a clad material) of any of these metals may be used. In particular, copper, which is inexpensive and has high heat dissipation, is preferably used for the base material. The lead may have a metal layer on the surface of the base material. For example, the metal layer contains gold, silver, aluminum, nickel, palladium, rhodium, copper, an alloy of any of these metals, or the like. The metal layer may be provided on the entire surface of the lead or on a portion of the surface of the lead. Further, different metal layers can be provided in a region on the upper surface of the lead and a region on the lower surface of the lead. For example, a metal layer formed on the upper surface of the lead is a metal layer formed of a plurality of layers that include a metal layer containing nickel and silver, and a metal layer formed on the lower surface of the lead is a metal layer that does not include a metal layer containing nickel. Further, a metal layer containing gold or the like formed on the upper surface of the lead can have a greater thickness than a metal layer containing gold or the like formed on the lower surface of the lead. If a metal layer containing silver is formed on the outermost surface of the lead, a protective layer of silicon oxide or the like is preferably provided on the surface of the metal layer containing silver. Accordingly, discoloration of the metal layer containing silver due to sulfur components in the atmosphere or the like can be suppressed. The protective layer can be formed by a vacuum process such as sputtering.

The first electrically-conductive part 11 may be any member as long as a current can flow through the first electrically-conductive part 11, and a current for causing the light-emitting element 2 to emit light does not have to flow through the first electrically-conductive part 11. The first electrically-conductive part 11 can also be used as a heat dissipation part in the light-emitting device 100. The first electrically-conductive part 11 can include a metal material or the like having electrical conductivity and good heat dissipation.

### (Light-Emitting Element 2)

The light-emitting device 100 includes at least one light-emitting element 2. In the example illustrated in FIG. 1 to FIG. 3, the light-emitting device 100 includes the first light-emitting element 21, the second light-emitting element 22, and the third light-emitting element 23. The quantity of light-emitting elements 2 included in the light-emitting device 100 may be one, two, three, or four or more. In FIG. 1 to FIG. 3, to indicate that a plurality of light-emitting elements 2 include the first light-emitting element 21, the second light-emitting element 22, and the third light-emitting element 23, the reference numerals of the light-emitting elements 2 are written together with the reference numerals of the first light-emitting element 21, the second light-emitting element 22, and the third light-emitting element 23. In the drawings described below, reference numerals may be written together for a similar purpose.

In the example illustrated in FIG. 1 to FIG. 3, the first light-emitting element 21, the second light-emitting element 22, and the third light-emitting element 23 are arranged at the center of the support 1. By arranging the plurality of light-emitting elements 2 at the center of the support 1, the plurality of light-emitting elements 2 can be arranged at a high density, and the positions of the plurality of light-emitting elements 2 can be made less likely to change even when the orientation of the light-emitting device 100 is changed when being mounted.

A light-emitting element 2 includes a semiconductor layered body. For example, the semiconductor layered body includes a substrate such as a sapphire or gallium nitride substrate, an n-type semiconductor layer and a p-type semiconductor layer disposed on the substrate, and a light emitting layer interposed between the n-type semiconductor layer and the p-type semiconductor layer. Further, the light-emitting element 2 includes an n-side electrode electrically connected to the n-type semiconductor layer and a p-side electrode electrically connected to the p-type semiconductor layer. The n-side electrode and the p-side electrode constitute a portion of the upper surface of the light-emitting element 2. The light-emitting element 2 does not have to include a substrate such as a sapphire or gallium nitride substrate. With this configuration, the size of the light-emitting element 2 can be easily reduced.

The light emitting layer may have a structure with a single active layer, such as a double heterostructure or a single quantum well (SQW) structure, or a structure with a group of active layers, such as a multiple quantum well (MQW) structure. The light emitting layer can emit visible light or ultraviolet light. The light emitting layer can emit blue to red light as the visible light. The semiconductor layered body including such a light emitting layer can include, for example, InₓAl_{y}Ga_{1-x-y}N (0 <_ x, 0 <_ y, x + y ≤ 1). The semiconductor layered body can include at least one light emitting layer that can emit light as described above. For example, the semiconductor layered body may include one or more light emitting layers between an n-type semiconductor layer and a p-type semiconductor layer or may have a structure in which an n-type semiconductor layer, a light-emitting layer, and a p-type semiconductor layer are repeatedly layered multiple times. If the semiconductor layered body includes a plurality of light emitting layers, the semiconductor layered body may include light emitting layers having different peak wavelengths or light emitting layers having the same peak wavelength. The expression "same peak wavelength" allows for, for example, a variation of approximately several nanometers. Such a combination of light emitting layers can be appropriately selected. If the semiconductor layered body includes two light emitting layers, for example, a combination of light emitting layers can be selected from blue light and blue light, green light and green light, red light and red light, ultraviolet light and ultraviolet light, blue light and green light, blue light and red light, and green light and red light, or the like. The light emitting layers may include a plurality of active layers having different peak wavelengths or a plurality of active layers having the same peak wavelength.

The first light-emitting element 21 emits light having a first peak wavelength. A wavelength at which the output value is highest in an optical spectrum of light emitted from the first light-emitting element 21 is referred to as the first peak wavelength. In the example illustrated in FIG. 1 to FIG. 3, the first light-emitting element 21 emits blue light. The first light-emitting element 21 may emit green light, red light, or the like.

The second light-emitting element 22 emits light having a second peak wavelength different from the first peak wavelength. A wavelength at which the output value is highest in an optical spectrum of light emitted from the second light-emitting element 22 is referred to as the second peak wavelength. In the example illustrated in FIG. 1 to FIG. 3, the second light-emitting element 22 emits green light. The second light-emitting element 22 may emit blue light, red light, or the like.

The third light-emitting element 23 emits light having a third peak wavelength different from the first peak wavelength and the second peak wavelength. A wavelength at which the output value is highest in an optical spectrum of light emitted from the third light-emitting element 23 is referred to as the third peak wavelength. In the example illustrated in FIG. 1 to FIG. 3, the third light-emitting element 23 emits red light. The third light-emitting element 23 may emit blue light, green light, or the like.

### (Integrated Circuit 3)

In the example illustrated in FIG. 1 to FIG. 3, the integrated circuit 3 is an electronic circuit such as a large scale integration (LSI) circuit that drives a light-emitting element 2 to emit light. A drive signal for the integrated circuit 3 is supplied to the integrated circuit 3 via the second electrically-conductive part 12. For example, the integrated circuit 3 may have the following specifications and functions. However, the specifications and functions of the integrated circuit 3 are not limited to the following.
- 488 Hz, 12-bit pulse width modulation (PWM) control
- Temperature correction function
- 8-bit luminance resolution (red, green, blue)
- Dimming function
- Maximum of 4079 light-emitting devices such as light emitting diodes (LEDs) can be connected in a daisy chain
- Bidirectional communication and half-duplex communication are possible
- 16 multicast address group is supported
- Built-in oscillator (OSC)
- Maximum length in the first direction D 1: 2.29 mm
- Maximum length in the second direction D2: 0.73 mm

Numbers attached to the inside of the integrated circuit 3 in FIG. 1 to FIG. 3 represent pin numbers of a plurality of pins included in the integrated circuit 3. Pin names, types, and descriptions corresponding to the pin numbers are illustrated in Table 1 below. A chip select signal in Table 1 means a signal for selecting any one of the first light-emitting element 21, the second light-emitting element 22, or the third light-emitting element 23 included in the light-emitting device 100.

**[Table 1]**

| PIN NUMBER | PIN NAME | TYPE | DESCRIPTION | CONNECTION DESTINATION |
|---|---|---|---|---|
| 1 | SDO_OUT | OUT | DATA OUTPUT | ELECTRICALLY-CONDUCTIVE PART 51 |
| 2 | SDI_IN | IN | DATA SIGNAL INPUT | ELECTRICALLY-CONDUCTIVE PART 52 |
| 3 | SCLK_IN | IN | CLOCK SIGNAL INPUT | ELECTRICALLY-CONDUCTIVE PART 53 |
| 4 | CSX_IN | IN | CHIP SELECT SIGNAL INPUT | SECOND ELECTRICALLY-CONDUCTIVE PART 12 |
| 5 | IOVCC_IN | IN | LDO INPUT (1.8 V) | ELECTRICALLY-CONDUCTIVE PART 54 |
| 6 | DGND | GND | GROUND | FIRST ELECTRICALLY-CONDUCTIVE PART 11 |
| 7 | VCC5 | Power | DC POWER SOURCE VOLTAGE | ELECTRICALLY-CONDUCTIVE PART 55 |
| 8 | AGND | GND | GROUND | FIRST ELECTRICALLY-CONDUCTIVE PART 11 |
| 9 | BLUE | OUT | OUTPUT TO FIRST LIGHT EMITTING ELEMENT | FIRST LIGHT EMITTING ELEMENT 21 |
| 10 | PGND1 | GND | POWER GROUND OF THIRD LIGHT EMITTING ELEMENT | FIRST ELECTRICALLY-CONDUCTIVE PART 11 |
| 11 | RED | OUT | OUTPUT TO THIRD LIGHT EMITTING ELEMENT | THIRD LIGHT EMITTING ELEMENT 23 |
| 12 | PGND2 | GND | POWER GROUND OF SECOND LIGHT EMITTING ELEMENT | FIRST ELECTRICALLY-CONDUCTIVE PART 11 |
| 13 | GREEN | OUT | OUTPUT TO SECOND LIGHT EMITTING ELEMENT | ELECTRICALLY-CONDUCTIVE PART 56 SECOND LIGHT EMITTING ELEMENT 22 |
| 14 | PGND3 | GND | POWER GROUND OF FIRST LIGHT EMITTING ELEMENT | FIRST ELECTRICALLY-CONDUCTIVE PART 11 |
| 15 | IOVCC_OUT | OUT | LDO OUTPUT (1.8 V) | ELECTRICALLY-CONDUCTIVE PART 57 |
| 16 | CSX_OUT | OUT | CHIP SELECT SIGNAL OUTPUT | THIRD ELECTRICALLY-CONDUCTIVE PART 13 |
| 17 | SCLK_OUT | OUT | CLOCK SIGNAL OUTPUT | ELECTRICALLY-CONDUCTIVE PART 58 |
| 18 | SDI_OUT | OUT | DATA SIGNAL OUTPUT | ELECTRICALLY-CONDUCTIVE PART 59 |
| 19 | SDO_IN | IN | DATA INPUT | ELECTRICALLY-CONDUCTIVE PART 60 |

A pin with pin number 1 of the integrated circuit 3 is connected to the electrically-conductive part 51 in FIG. 3. A pin with pin number 2 of the integrated circuit 3 is connected to the electrically-conductive part 52 in FIG. 3. A pin with pin number 3 of the integrated circuit 3 is connected to the electrically-conductive part 53 in FIG. 3. A pin with pin number 4 of the integrated circuit 3 is connected to the second electrically-conductive part 12 in FIG. 3. A pin with pin number 5 of the integrated circuit 3 is connected to the electrically-conductive part 54 in FIG. 3. A pin with pin number 6 of the integrated circuit 3 is connected to the first electrically-conductive part 11 in FIG. 3. A pin with pin number 7 of the integrated circuit 3 is connected to the electrically-conductive part 55 in FIG. 3. A pin with pin number 8 of the integrated circuit 3 is connected to the first electrically-conductive part 11 in FIG. 3. A pin with pin number 9 of the integrated circuit 3 is connected to the first light-emitting element 21 in FIG. 3. A pin with pin number 10 of the integrated circuit 3 is connected to the first electrically-conductive part 11 in FIG. 3. A pin with pin number 11 of the integrated circuit 3 is connected to the third light-emitting element 23 in FIG. 3. A pin with pin number 12 of the integrated circuit 3 is connected to the first electrically-conductive part 11 in FIG. 3. A pin with pin number 13 of the integrated circuit 3 is connected to the electrically-conductive part 56 in FIG. 3. A pin with pin number 14 of the integrated circuit 3 is connected to the first electrically-conductive part 11 in FIG. 3. A pin with pin number 15 of the integrated circuit 3 is connected to the electrically-conductive part 57 in FIG. 3. A pin with pin number 16 of the integrated circuit 3 is connected to the third electrically-conductive part 13 in FIG. 3. A pin with pin number 17 of the integrated circuit 3 is connected to the electrically-conductive part 58 in FIG. 3. A pin with pin number 18 of the integrated circuit 3 is connected to the electrically-conductive part 59 in FIG. 3. A pin with pin number 19 of the integrated circuit 3 is connected to the electrically-conductive part 60 in FIG. 3. The positions of the pins are not particularly limited. For example, instead of the pin with the pin number 8 being connected to the first electrically-conductive part 11, a pin located between the pin with the pin number 8 and the pin with the pin number 9 may be connected to the first electrically-conductive part 11.

### [Second Embodiment]

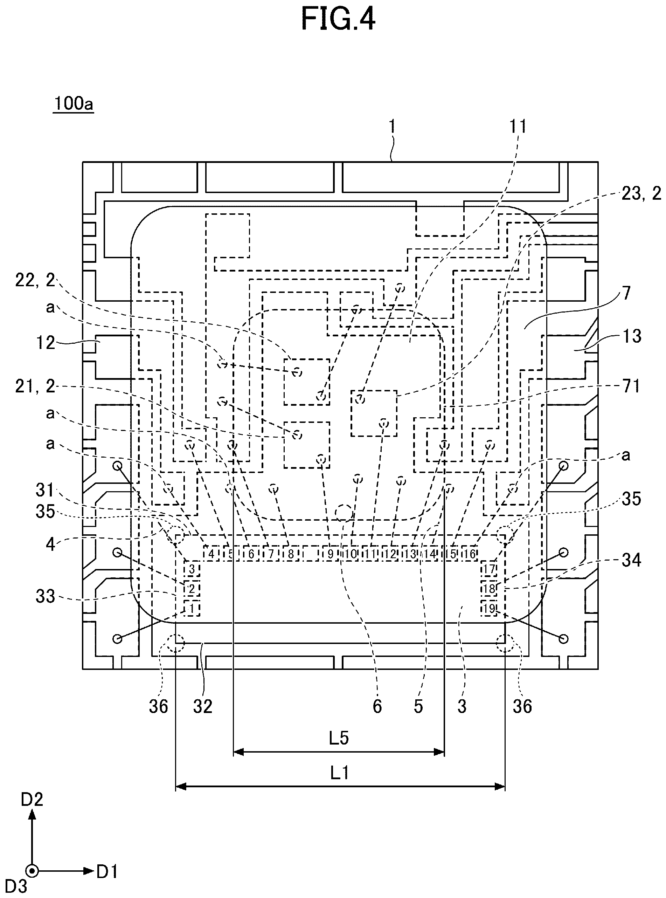

Next, a light-emitting device according to a second embodiment will be described with reference to FIG. 4. FIG. 4 is a schematic top view illustrating an example of a light-emitting device 100a according to the second embodiment. The same names and reference numerals as those in the above-described embodiment denote the same or similar members or configurations, and a detailed description thereof will be appropriately omitted. The same applies to the description of embodiments to be described later.

As illustrated in FIG. 4, the light-emitting device 100a according to the second embodiment mainly differs from the light-emitting device 100 according to the first embodiment in that the light-emitting device 100a includes a first reflective member 7 surrounding the first light-emitting element 21 in a top view. The first reflective member 7 covers at least a portion of each of the first outer edge 31, the third outer edge 33, and the fourth outer edge 34 of the integrated circuit 3. With this configuration, detachment of the integrated circuit 3 from the support 1 can be suppressed. The first reflective member 7 may cover the second outer edge 32 of the integrated circuit 3. Alternatively, the first reflective member 7 does not have to cover the second outer edge 32 of the integrated circuit 3 as illustrated in FIG. 4. For example, if the first reflective member 7 covers the second outer edge 32 of the integrated circuit 3, because the area of the support 1 located outward of the second outer edge 32 needs to be increased to some extent, the size of the light-emitting device would be increased. In the present embodiment, the first reflective member 7 does not cover the second outer edge 32, thereby facilitating a reduction in the area of the support 1 located outward of the second outer edge 32. Accordingly, the light-emitting device 100a can be reduced in size in the second direction D2.

In the light-emitting device 100a illustrated in FIG. 4, a maximum length L5 of an opening 71 defined by the lower ends of the inner lateral surfaces of the first reflective member 7 in the first direction D1 is smaller than the maximum length L1 of the integrated circuit 3 in the first direction D1. With this configuration, the length of the first reflective member 7 in the first direction D1 can be reduced, and thus the light-emitting device 100a illustrated in FIG. 4 can be reduced in size in the first direction D1.

In the light-emitting device 100a illustrated in FIG. 4, the outer edge of the integrated circuit 3 has a rectangular shape in a top view. The first reflective member 7 covers two corners 35 of the integrated circuit 3 located closer to the first light-emitting element 21. Two corners 36 of the integrated circuit 3 located on the opposite side from the first light-emitting element 21 are not covered by the first reflective member 7. The first reflective member 7 covers the two corners 35 of the integrated circuit 3 located closer to the first light-emitting element 21, and thus detachment of the integrated circuit 3 from the support 1 can be suppressed. Further, the two corners 36 of the integrated circuit 3 located on the opposite side from the first light-emitting element 21 are not covered by the first reflective member 7, and thus the volume of the first reflective member 7 can be reduced. A variation in the shape of the first reflective member 7 can be reduced according to the reduction in the volume of the first reflective member 7. Accordingly, in a plurality of light-emitting devices 100a, variations in appearance of the light-emitting devices 100a can be reduced.

### (First Reflective Member 7)

The first reflective member 7 is a member having reflectivity with respect to light emitted from a light-emitting element 2. Including the first reflective member 7 in the light-emitting device 100a can suppress absorption of light emitted from the light-emitting element 2 by the support. Accordingly, the light extraction efficiency of the light-emitting device 100a can be improved. In the present specification, the term "reflective" means that the reflectance at the peak wavelength of the light-emitting element 2 is 50% or more. When the light-emitting device 100a includes a plurality of light-emitting elements 2, it is sufficient that the reflectance at the peak wavelength of at least one light-emitting element 2 is 50% or more.

For example, the first reflective member 7 includes a resin material, which serves as a base material, and a light-reflective substance. As the resin material of the first reflective member 7, a thermosetting resin, a thermoplastic resin, or the like can be used. Examples of the thermoplastic resin include a polyphthalamide resin, polybutylene terephthalate (PBT), and an unsaturated polyester. Examples of the thermosetting resin include an epoxy resin, a modified epoxy resin, a silicone resin, a modified silicone resin, and the like. In particular, a thermosetting resin, such as an epoxy resin or a silicone resin, which has good heat resistance and light resistance, is preferably used for as the resin material.

The first reflective member 7 preferably contains the light-reflective substance in the resin material serving as the base material. As the light-reflective substance, a material that is less likely to absorb light emitted from the light-emitting element 2 and has a large difference in refractive index from the resin material serving as the base material is preferably used. As the light-reflective substance, titanium oxide, zinc oxide, silicon oxide, zirconium oxide, aluminum oxide, or aluminum nitride can be used. The first reflective member 7 may contain a light-absorbing substance in the above-described resin material serving as the base material. For example, a dark-colored pigment such as carbon black can be used as the light-absorbing substance. For example, the first reflective member 7 may be composed of an inorganic material containing boron nitride or alkali metal silicate. The first reflective member 7 may further contain titanium oxide or zirconium oxide.

The first reflective member 7 may be in contact with the light-emitting element 2 or may be separated from the light-emitting element 2. In a case in which the first reflective member 7 is in contact with the light-emitting element 2, the area of the upper surface of the support 1 covered by the first reflective member 7 can be easily increased. Accordingly, light from the light-emitting element 2 can be less likely to be absorbed by the support 1. In a case in which the first reflective member 7 is separated from the light-emitting element 2, light from the lateral surfaces of the light-emitting element 2 can further be extracted.

As illustrated in FIG. 4, one first reflective member 7 may surround the entire periphery of the light-emitting element(s) 2. Alternatively, a plurality of first reflective members 7 may surround the entire periphery of the light-emitting element(s) 2. In a case in which one first reflective member 7 surrounds the entire periphery of the light-emitting element(s) 2, the area of the upper surface of the support 1 covered by the first reflective member 7 can be easily increased. Accordingly, light from the light-emitting element(s) 2 is less likely to be absorbed by the support 1. In a case in which a plurality of first reflective members 7 surround the light-emitting element(s) 2, the volume of each of the plurality of first reflective members 7 can be easily decreased. Accordingly, variations in the shape of the plurality of first reflective members 7 can be easily reduced, thereby facilitating an improvement in the yield of the light-emitting device 100a.

### [Third Embodiment]

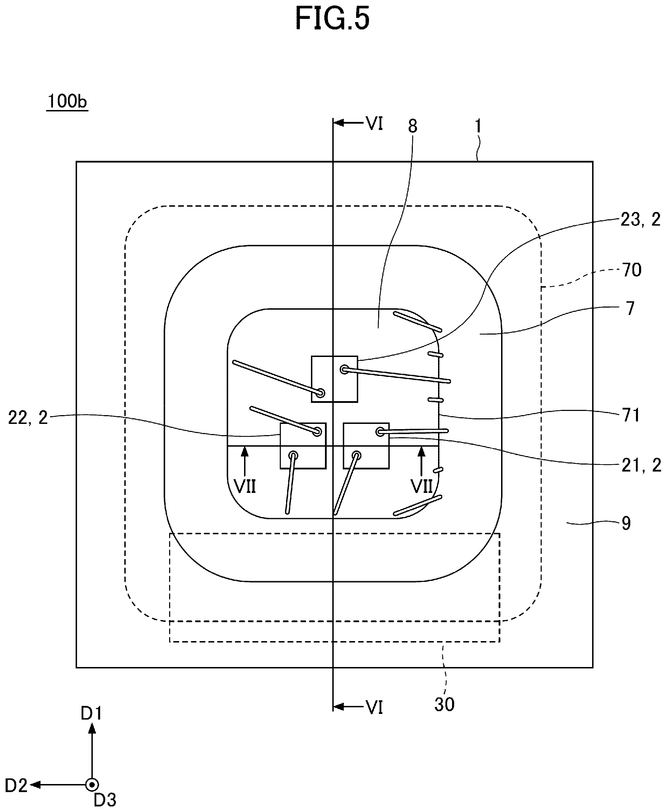

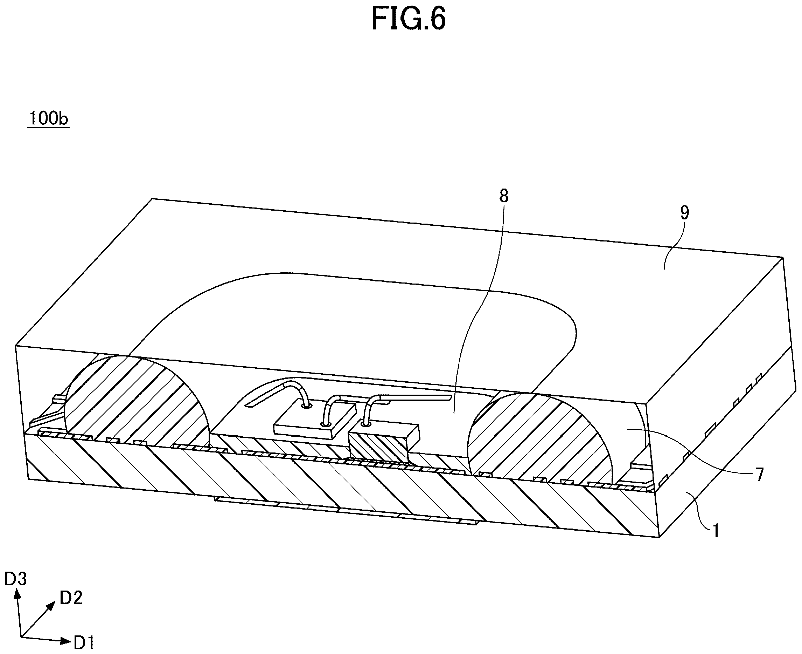

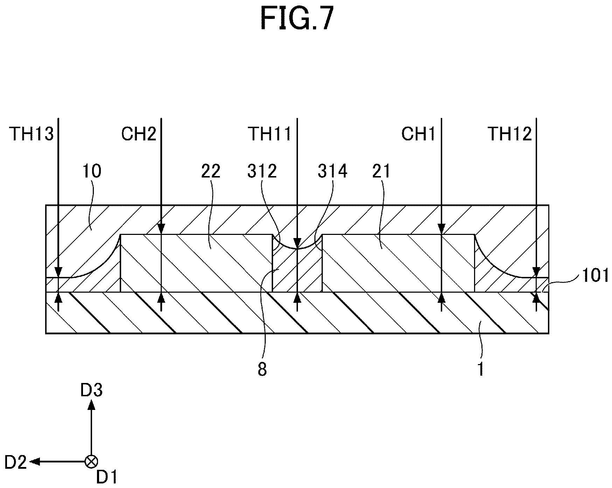

Next, a light-emitting device according to a third embodiment will be described with reference to FIG. 5 to FIG. 7. FIG. 5 is a schematic top view illustrating an example of a light-emitting device 100b according to the third embodiment. FIG. 6 is a schematic perspective view illustrating an example of the light-emitting device 100b taken through line VI-VI of FIG. 5. FIG. 7 is a schematic cross-sectional view taken through line VII-VII of FIG. 5.

As illustrated in FIG. 5 and FIG. 6, the light-emitting device 100b according to the third embodiment mainly differs from the light-emitting device 100a according to the second embodiment in that the light-emitting device 100b includes a cover member 9 that covers the outer lateral surfaces of each of a first reflective member 7 and the integrated circuit 3 in a top view. In the example illustrated in FIG. 5, outer lateral surfaces 30 indicate outer lateral surfaces of the integrated circuit 3, and outer lateral surfaces 70 indicate outer lateral surfaces of the first reflective member 7. Further, in the example illustrated in FIG. 5 and FIG. 6, the light-emitting device 100b includes a second reflective member 8 that covers the lateral surfaces of the first light-emitting element 21 and the upper surface of the support 1. In the present embodiment, the outer lateral surfaces of each of the first reflective member 7 and the integrated circuit 3 are covered by the cover member 9. Therefore, the possibility that an external force is applied to the first reflective member 7 and the integrated circuit 3 can be reduced. Thus, the first reflective member 7 and the integrated circuit 3 can be protected from an external force.

A cross section passing through the first light-emitting element 21 and the second light-emitting element 22 and perpendicular to a first surface 101 is referred to as a first cross section. In the first cross section as illustrated in FIG. 7, a first height TH11, which is the minimum height of the second reflective member 8 located between the first light-emitting element 21 and the second light-emitting element 22, is greater than a second height TH12, which is the minimum height of the second reflective member 8 located outward of the first light-emitting element 21. Further, the first height TH11 is greater than a third height TH13, which is the minimum height of the second reflective member 8 located outward of the second light-emitting element 22. Accordingly, light emitted from the first light-emitting element 21 is less likely to be absorbed by the second light-emitting element 22, and also light emitted from the second light-emitting element 22 is less likely to be absorbed by the first light-emitting element 21. In the present specification, the expression "located outward of a light-emitting element" means that the distance from a position to the outer edge of the light-emitting device located closer to the light-emitting element is shorter than the distance from the light-emitting element to the outer edge of the light-emitting device, in the lateral direction.

As illustrated in FIG. 7, a first element height CH1, which is the maximum height of the first light-emitting element 21, is preferably 0.9 times or more and 1.1 times or less as large as a second element height CH2, which is the maximum height of the second light-emitting element 22. With this configuration, a portion in which the first light-emitting element 21 and the second light-emitting element 22 do not overlap each other in the third direction D3 can be reduced. Accordingly, the color mixing properties of the light-emitting device 100 can be easily improved. The difference between the first element height CH1 and the second element height CH2 is preferably 30 pm or less.

### (Second Reflective Member 8)

As described above, the second reflective member 8 is a member covering the lateral surfaces of the first light-emitting element 21 and the upper surface of the support 1. From the second reflective member 8, at least a portion of the upper surface of the first light-emitting element 21 is exposed. The second reflective member 8 can include a plurality of reflective particles and a base material formed of a light-transmissive material. The same or similar light-reflective substance as in the first reflective member 7 can be used for the reflective particles. For example, the same or similar resin material as in the first reflective member 7 can be used for the base material of the second reflective member 8. In the second reflective member 8, the reflective particles may be sedimented, but the reflective particles do not have to be sedimented. Spontaneous sedimentation, centrifugal sedimentation, or the like can be utilized to sediment the reflective particles. For example, the centrifugal sedimentation is performed by using a centrifuge. For example, the second reflective member 8 may be composed of an inorganic material containing boron nitride or alkali metal silicate. The second reflective member 8 may further contain titanium oxide or zirconium oxide.

### (Cover Member 9)

As described above, the cover member 9 is a member covering the outer lateral surfaces of each of the first reflective member 7 and the integrated circuit 3 in a top view. The cover member 9 includes a light reflective material that shields light by reflecting the light. The cover member 9 functions to return light, which is emitted from a light-emitting element 2 and reaches the cover member 9 through the first reflective member 7, into the first reflective member 7. Accordingly, the light extraction efficiency of the light-emitting device 100b can be improved.

As a resin used for a base material of the cover member 9, a thermoplastic resin or a thermosetting resin can be used. Examples of the thermoplastic resin include a polyamide resin, a polyphthalamide resin, a liquid crystal polymer, polybutylene terephthalate (PBT), an unsaturated polyester, and the like. Examples of the thermosetting resin include an epoxy resin, a modified epoxy resin, a silicone resin, a modified silicone resin, and the like.

The cover member 9 can be formed by using a resin material to which light reflectivity is imparted by containing particles of a light-reflective substance as a filler in a base material. As the light-reflective substance, for example, titanium oxide, aluminum oxide, zirconium oxide, magnesium oxide, or the like can be used. The content of the filler, which is the light-reflective substance, in the cover member 9 may be 5% by mass or more and 60% by mass or less, and is preferably 10% by mass or more and 50% by mass or less. The average particle diameter of the filler is preferably approximately 0.5 pm or more and 15 pm or less. By setting the size of the filler to be in this range, the cover member 9 can obtain at least one of good strength or light reflectivity. The cover member 9 may be formed of a member that absorbs light. The cover member 9 may contain a light-absorbing substance in the above-described resin material serving as the base material. As the light-absorbing substance, a dark-colored pigment such as carbon black can be used.

The resin material to which at least one of light reflectivity or strength is imparted by containing the filler in the base material can be used to form the cover member 9 by a molding method with a mold, such as a transfer molding method, an injection molding method, or a compression molding method, a coating method such as a screen printing method, or the like.

### (Second Cover Member 10)

A second cover member 10 illustrated in FIG. 7 is a member covering at least a portion of the upper surface of the first light-emitting element 21 and at least a portion of the upper surface of the second light-emitting element 22. Thus, the upper surface of the first light-emitting element 21 and the upper surface of the second light-emitting element 22 can be protected from an external force or the like. In the present embodiment, the upper surface of the second cover member 10 is a light emitting surface of the light-emitting device 100.

As a base material of the second cover member 10, a material the same as or similar to the base material of the cover member 9 can be used. The second cover member 10 may contain a plurality of reflective particles. By containing the plurality of reflective particles in the second cover member 10, light emitted from the upper surface of the first light-emitting element 21 and light emitted from the upper surface of the second light-emitting element 22 can be easily diffused in the second cover member 10. As a result, the color mixing properties of the light-emitting device 100 can be easily improved. The second cover member 10 may include a wavelength conversion member.

### [Fourth Embodiment]

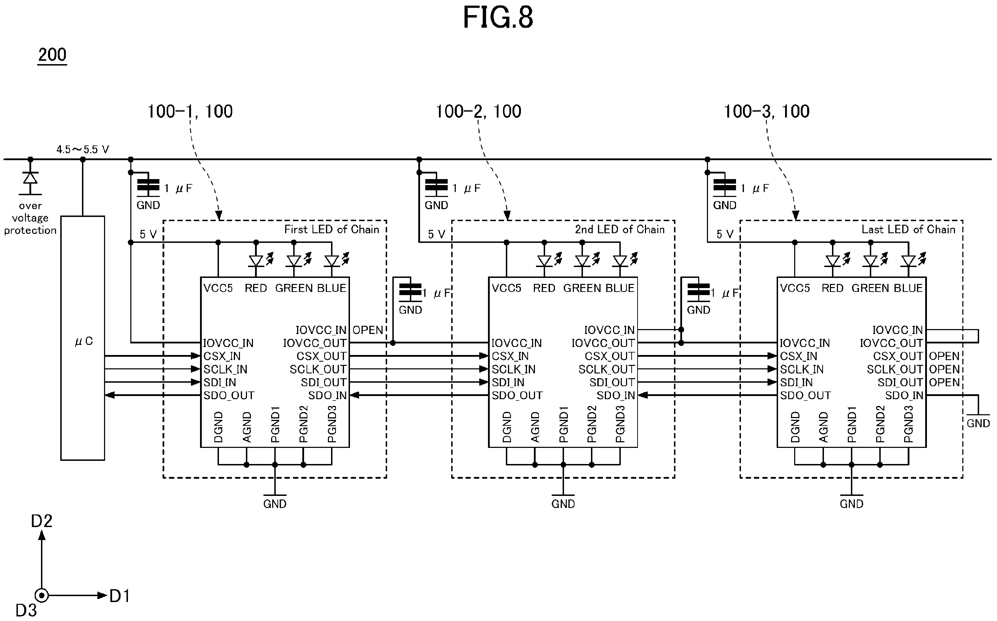

Next, a light-emitting unit according to a fourth embodiment will be described with reference to FIG. 8. FIG. 8 is a schematic diagram illustrating an example of a system configuration of a light-emitting unit 200 according to the fourth embodiment.

The light-emitting unit 200 illustrated in FIG. 8 includes a plurality of light-emitting devices 100 as described above. The plurality of light-emitting devices 100 are arranged in the first direction D1. In the example illustrated in FIG. 8, the plurality of light-emitting devices 100 included in the light-emitting unit 200 include a first light-emitting device 100-1, a second light-emitting device 100-2, and a third light-emitting device 100-3. In the present embodiment, by arranging the plurality of light-emitting devices 100 in the first direction D1, the light-emitting unit 200 including the plurality of light-emitting devices 100 can be reduced in size in the second direction D2. The light-emitting unit 200 may include a plurality of light-emitting devices 100a or a plurality of light-emitting devices 100b. Alternatively, the light-emitting unit 200 may include a combination of one or more light-emitting devices 100, one or more light-emitting devices 100a, and one or more light-emitting devices 100b.

Each of the plurality of light-emitting devices 100 illustrated in FIG. 8 has a built-in serial peripheral interface (SPI), and can communicate with a host controller via the SPI. The SPI is composed of signal lines including four lines: chip select, clock, and data lines (SDI and SDO). In the SPI, a clock signal is transmitted from a main device, which is a host controller, to a light-emitting device 100 serving as a replica, and the replica transmits or receives data in synchronization with the clock signal from the main device. The main device can control the plurality of light-emitting devices 100. The light-emitting unit 200 connects the plurality of light-emitting devices 100 in a daisy chain. In the daisy chain, one light-emitting device 100 is connected to the main device, and the light-emitting device 100 connected to the main device and the other light-emitting devices 100 are connected in a row. The one light-emitting device 100 transmits data to the next light-emitting device 100 while receiving data from the main device. Each of the plurality of light-emitting devices 100 can transmit and receive data between the preceding light-emitting device 100 and the following light-emitting device 100. In the light-emitting unit 200, the plurality of light-emitting devices 100 can be controlled by a single main device such as a microcontroller by connecting the light-emitting devices 100 in a daisy chain.

In the light-emitting unit 200 illustrated in FIG. 8, a second electrically-conductive part 12 of a light-emitting device 100 is connected to an input terminal configured to input an electrical signal from an adjacent light-emitting device 100, and a third electrically-conductive part 13 of the light-emitting device 100 is connected to an output terminal configured to output an electrical signal to the adjacent light-emitting device 100. In other words, in the light-emitting unit 200 illustrated in FIG. 8, the plurality of light-emitting devices 100 are connected in a daisy chain.

The above will be described more specifically. In the first light-emitting device 100-1 illustrated in FIG. 8, an electrically-conductive part 60 inputs data SDO_IN from the second light-emitting device 100-2. Further, in the first light-emitting device 100-1, a third electrically-conductive part 13 outputs a chip select signal CSX_OUT, an electrically-conductive part 58 outputs a clock signal SCLK_OUT, and an electrically-conductive part 59 outputs a data signal SDI_OUT to the adjacent second light-emitting device 100-2.

In the second light-emitting device 100-2 illustrated in FIG. 8, a second electrically-conductive part 12 inputs a chip select signal CSX_IN, an electrically-conductive part 53 inputs a clock signal SCLK_IN, and an electrically-conductive part 52 inputs a data signal SDI_IN from the adjacent first light-emitting device 100-1. In the second light-emitting device 100-2, an electrically-conductive part 51 outputs data SDO_ OUT to the adjacent first light-emitting device 100-1. Further, in the second light-emitting device 100-2, a third electrically-conductive part 13 outputs a chip select signal CSX_OUT, an electrically-conductive part 58 outputs a clock signal SCLK_OUT, and an electrically-conductive part 59 outputs a data signal SDI_OUT to the adjacent third light-emitting device 100-3.

In the third light-emitting device 100-3 illustrated in FIG. 8, a second electrically-conductive part 12 inputs a chip select signal CSX_IN, an electrically-conductive part 53 inputs a clock signal SCLK_IN, and an electrically-conductive part 52 inputs a data signal SDI_IN from the adjacent second light-emitting device 100-2. Further, in the third light-emitting device 100-3, an electrically-conductive part 51 outputs data SDO_OUT to the adjacent second light-emitting device 100-2.

In the light-emitting unit 200 illustrated in FIG. 8, by connecting the plurality of light-emitting devices 100 in a daisy chain, the light-emitting unit 200 including the plurality of light-emitting devices 100 can be reduced in size in the second direction D2, and also the management of wiring, connections, or the like of the plurality of light-emitting devices 100 can be efficiently performed.

In the light-emitting unit 200 illustrated in FIG. 8, a support 1 of each of the plurality of light-emitting devices 100 includes a fourth electrically-conductive part located on one side of an integrated circuit 3 in the first direction D1 and a fifth electrically-conductive part located on the other side of the integrated circuit 3 in the first direction D1. In the example illustrated in FIG. 8, the "one side" is the left side in a top view, and the "other side" is the right side in a top view. The electrically-conductive part 51, the electrically-conductive part 52, the electrically-conductive part 53, and the second electrically-conductive part 12 illustrated in FIG. 3 correspond to the fourth electrically-conductive part. The electrically-conductive part 60, the electrically-conductive part 59, the electrically-conductive part 58, and the third electrically-conductive part 13 illustrated in FIG. 3 correspond to the fifth electrically-conductive part.

Each of the fourth electrically-conductive part and the fifth electrically-conductive part can either input or output an electrical signal. The light-emitting unit 200 illustrated in FIG. 8 includes the fourth electrically-conductive part and the fifth electrically-conductive part. Thus, without increasing the size of the light-emitting unit 200 in the second direction D2, the quantity of inputs and outputs of electrical signals into and from each of the plurality of light-emitting devices 100 can be increased, and the degree of freedom in controlling each of the plurality of light-emitting devices 100 can be increased.

### [Fifth Embodiment]

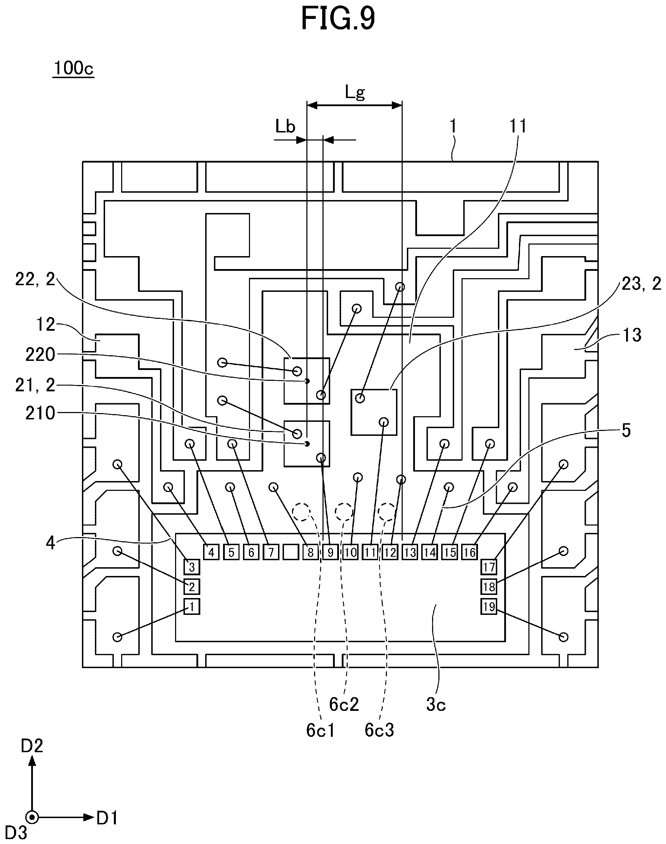

Next, a light-emitting device according to a fifth embodiment will be described. FIG. 9 is a schematic top view of a light-emitting device 100c according to a fifth embodiment.

The light-emitting device 100c according to the fifth embodiment differs from the light-emitting device 100 according to the first embodiment in that the light-emitting device 100c includes an integrated circuit 3c, a first via 6c1, a second via 6c2, and a third via 6c3. Each of the first via 6c1, the second via 6c2, and the third via 6c3 is a via provided in the support 1 and electrically connected to the first electrically-conductive part 11.

The first via 6c1, the second via 6c2, and the third via 6c3 are located between the first light-emitting element 21 and the integrated circuit 3c in the second direction D2. With this configuration, heat generated from the first light-emitting element 21 and the integrated circuit 3c can be released through the first via 6c1, the second via 6c2, and the third via 6c3 to an external substrate or the like on which the support 1 is disposed. As a result, the heat dissipation of the light-emitting device 100c can be improved.

The arrangement of some pins of the integrated circuit 3c differs from that of the integrated circuit 3 of the light-emitting device 100 according to the first embodiment. In FIG. 9, numbers applied to the inside of the integrated circuit 3c represent pin numbers of a plurality of pins included in the integrated circuit 3c. The pin names, types and descriptions corresponding to the pin numbers are illustrated in Table 2 below.

**[Table 2]**

| PIN NUMBER | PIN NAME | TYPE | DESCRIPTION | CONNECTION DESTINATION |
|---|---|---|---|---|
| 1 | SDO_OUT | OUT | DATA OUTPUT | ELECTRICALLY-CONDUCTIVE PART 51 |
| 2 | SDI_IN | IN | DATA SIGNAL INPUT | ELECTRICALLY-CONDUCTIVE PART 52 |
| 3 | SCLK_IN | IN | CLOCK SIGNAL INPUT | ELECTRICALLY-CONDUCTIVE PART 53 |
| 4 | CSX_IN | IN | CHIP SELECT SIGNAL INPUT | SECOND ELECTRICALLY-CONDUCTIVE PART 12 |
| 5 | IOVCC_IN | IN | LDO INPUT (1.8 V) | ELECTRICALLY-CONDUCTIVE PART 54 |
| 6 | DGND | GND | GROUND | FIRST ELECTRICALLY-CONDUCTIVE PART 11 |
| 7 | VCC5 | Power | DC POWER SOURCE VOLTAGE | ELECTRICALLY-CONDUCTIVE PART 55 |
| 8 | AGND | GND | GROUND | FIRST ELECTRICALLY-CONDUCTIVE PART 11 |
| 9 | BLUE | OUT | OUTPUT TO FIRST LIGHT EMITTING ELEMENT | FIRST LIGHT EMITTING ELEMENT 21 |
| 10 | PGND1 | GND | POWER GROUND OF FIRST LIGHT EMITTING ELEMENT | FIRST ELECTRICALLY-CONDUCTIVE PART 11 |
| 11 | RED | OUT | OUTPUT TO THIRD LIGHT EMITTING ELEMENT | THIRD LIGHT EMITTING ELEMENT 23 |
| 12 | PGND2 | GND | POWER GROUND OF THIRD LIGHT EMITTING ELEMENT | FIRST ELECTRICALLY-CONDUCTIVE PART 11 |
| 13 | GREEN | OUT | OUTPUT TO SECOND LIGHT EMITTING ELEMENT | ELECTRICALLY-CONDUCTIVE PART 56 SECOND LIGHT EMITTING ELEMENT 22 |
| 14 | PGND3 | GND | POWER GROUND OF SECOND LIGHT EMITTING ELEMENT | FIRST ELECTRICALLY-CONDUCTIVE PART 11 |
| 15 | IOVCC_OUT | OUT | LDO OUTPUT (1.8 V) | ELECTRICALLY-CONDUCTIVE PART 57 |
| 16 | CSX_OUT | OUT | CHIP SELECT SIGNAL OUTPUT | THIRD ELECTRICALLY-CONDUCTIVE PART 13 |
| 17 | SCLK_OUT | OUT | CLOCK SIGNAL OUTPUT | ELECTRICALLY-CONDUCTIVE PART 58 |
| 18 | SDI_OUT | OUT | DATA SIGNAL OUTPUT | ELECTRICALLY-CONDUCTIVE PART 59 |
| 19 | SDO_IN | IN | DATA INPUT | ELECTRICALLY-CONDUCTIVE PART 60 |

As indicated in Table 2, a pin with pin number 10 is a power ground of the first light-emitting element 21. A pin with pin number 12 is a power ground of the third light-emitting element 23. A pin with pin number 14 is a power ground of the second light-emitting element 22. In the integrated circuit 3c, these pins differ from those of the integrated circuit 3 included in the light-emitting device 100 according to the first embodiment.

In the integrated circuit 3c, a pin is disposed between a pin with pin number 9, which is an output pin to the first light-emitting element 21, and a pin with pin number 11, which is an output pin to the third light-emitting element 23. For example, the temperature of the integrated circuit 3c is likely to increase in the vicinity of an output pin that controls a current to a light-emitting element. By disposing the pin between the output pin to the first light-emitting element 21 and the output pin to the third light-emitting element 23, the distance between the output pins increases as compared to when the output pin to the first light-emitting element 21 and the output pin to the third light-emitting element 23 are located adjacent to each other. As a result, an increase in the temperature of the integrated circuit 3c can be easily reduced.

In the integrated circuit 3c, the pin with the pin number 10, which is a power ground pin of the first light-emitting element 21, is disposed adjacent to the pin with the pin number 9, which is the output pin to the first light-emitting element 21. Thus, in the light-emitting device 100c, external noise to the output pin to the first light-emitting element 21 and external noise to the power ground pin of the first light-emitting element 21 are substantially the same, and as a result, the external noise is cancelled. Accordingly, an influence of external noise can be easily reduced, and also internal noise to the output pin to the first light-emitting element 21 can be easily reduced.

In the light-emitting device 100c,a minimum distance Lg between a geometric center 220 of the second light-emitting element 22 and a pin with pin number 13, which is an output pin to the second light-emitting element 22, in the first direction D1 is greater than a minimum distance Lb between a geometric center 210 of the first light-emitting element 21 and the pin with the pin number 9, which is the output pin to the first light-emitting element 21, in the first direction D1. Thus, the distance between the second light-emitting element 22, which has a higher current value and is more likely to increase in temperature than the first light-emitting element 21, and the output pin to the second light-emitting element 22 increases as compared to the distance between the first light-emitting element 21 and the output pin to the first light-emitting element 21. As a result, an increase in the temperature of the light-emitting device 100c can be easily reduced. The light-emitting device 100c according to the present embodiment may be combined with the light-emitting device 100a according to the second embodiment or the light-emitting device 100b according to the third embodiment.

### [Sixth Embodiment]

Next, a light-emitting unit according to a sixth embodiment will be described. The light-emitting unit according to the sixth embodiment differs from the light-emitting unit 200 according to the fourth embodiment in that the light-emitting unit according to the sixth embodiment includes a plurality of light-emitting devices 100 and a light guide member disposed above the plurality of light-emitting devices 100 and configured to guide light emitted from the plurality of light-emitting devices 100.

### (First Example)

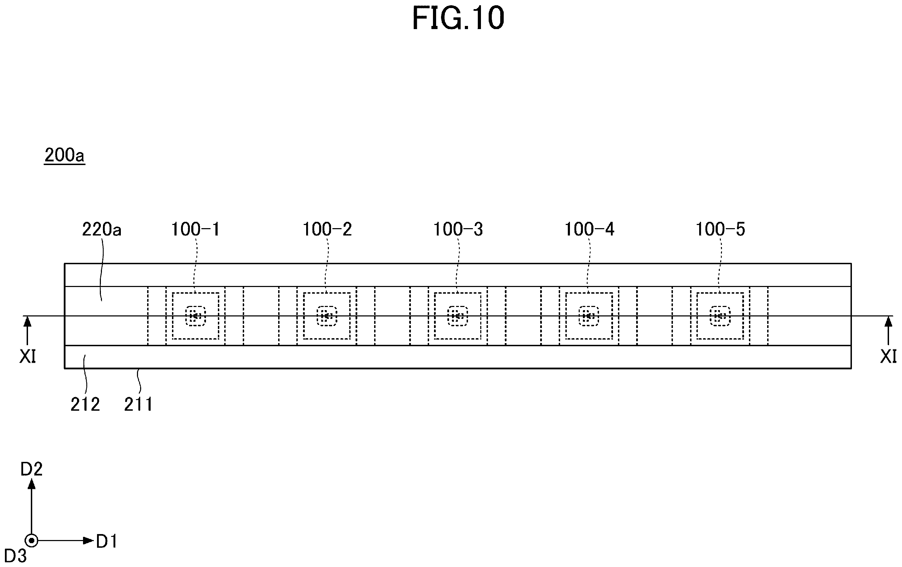

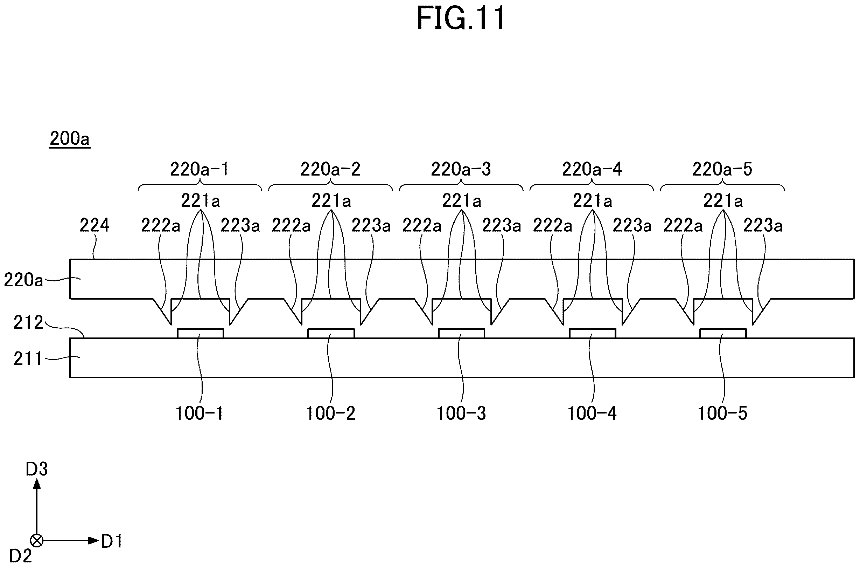

FIG. 10 is a schematic top view of a light-emitting unit 200a according to a first example of the sixth embodiment. FIG. 11 is a schematic cross-sectional view taken through line XI-XI of FIG. 10.

The light-emitting unit 200a includes a substrate 211, a first light-emitting device 100-1, a second light-emitting device 100-2, a third light-emitting device 100-3, a fourth light-emitting device 100-4, a fifth light-emitting device 100-5, and a light guide member 220a. The light-emitting unit 200a is, for example, a light-emitting unit used in ambient lighting.

In the first example illustrated in FIG. 10, the first light-emitting device 100-1, the second light-emitting device 100-2, the third light-emitting device 100-3, the fourth light-emitting device 100-4, and the fifth light-emitting device 100-5 are disposed on an upper surface 212 of the substrate 211 and are arranged side by side in the first direction D1. Any of the light-emitting device 100, the light-emitting device 100a, the light-emitting device 100b, and the light-emitting device 100c can be applied to the first light-emitting device 100-1, the second light-emitting device 100-2, the third light-emitting device 100-3, the fourth light-emitting device 100-4, and the fifth light-emitting device 100-5. For convenience of description, the first light-emitting device 100-1, the second light-emitting device 100-2, the third light-emitting device 100-3, the fourth light-emitting device 100-4, and the fifth light-emitting device 100-5 may be collectively referred to as a light-emitting device 100 when they are not distinguished from each other.

The light guide member 220a is a member configured to allow light emitted from the light-emitting device 100 to enter the inside of the light guide member 220a, guide the light through the inside of the light guide member 220a, and then exit the light from the inside of the light guide member 220a to the outside. In a top view, the light guide member 220a has a substantially rectangular outer shape, with the longer side being in the first direction D1 in which the first light-emitting device 100-1, the second light-emitting device 100-2, the third light-emitting device 100-3, and the fourth light-emitting device 100-4 are arranged. The light guide member 220a has a transmittance of 60% or more with respect to the light emitted from the light-emitting device 100.

The light guide member 220a includes a first light guide part 220a-1, a second light guide part 220a-2, a third light guide part 220a-3, a fourth light guide part 220a-4, a fifth light guide part 220a-5, and a light exiting part 224. The first light guide part 220a-1 is disposed above the first light-emitting device 100-1 and guides light from the first light-emitting device 100-1. The second light guide part 220a-2 is disposed above the second light-emitting device 100-2 and guides light from the second light-emitting device 100-2. The third light guide part 220a-3 is disposed above the third light-emitting device 100-3 and guides light from the third light-emitting device 100-3. The fourth light guide part 220a-4 is disposed above the fourth light-emitting device 100-4 and guides light from the fourth light-emitting device 100-4. The fifth light guide part 220a-5 is disposed above the fifth light-emitting device 100-5 and guides light from the fifth light-emitting device 100-5.

Each of the first light guide part 220a-1, the second light guide part 220a-2, the third light guide part 220a-3, the fourth light guide part 220a-4, and the fifth light guide part 220a-5 includes a light incident portion 221a, a first reflective portion 222a, and a second reflective portion 223a.

The light incident portion 221a is a portion through which light from the light-emitting device 100 passes when entering the inside of the light guide member 220a. Further, the light incident portion 221a defines a recessed portion that is recessed upward in a cross-sectional view along the first direction D1 and the third direction illustrated in FIG. 11. The light incident portion 221a has a substantially rectangular outer shape in a top view illustrated in FIG. 10.

The first reflective portion 222a and the second reflective portion 223a reflect upward a portion of the light that has entered from the light incident portion 221a and reached the first reflective portion 222a and the second reflective portion 223a. The first reflective portion 222a and the second reflective portion 223a are arranged side by side, with the light incident portion 221a interposed therebetween in the first direction D 1.

A portion of the light that is guided through the inside of the light guide member 220a from the light incident portion 221a exits from the light guide member 220a through the light exiting part 224. Further, a portion of the light that is guided through the inside of the light guide member 220a from the light incident portion 221a is reflected by the first reflective portion 222a or the second reflective portion 223a, and then exits from the light guide member 220a through the light exiting part 224. The light exiting part 224 is a light exiting part common to the first light guide part 220a-1, the second light guide part 220a-2, the third light guide part 220a-3, the fourth light guide part 220a-4, and the fifth light guide part 220a-5.

In the light-emitting unit 200a, by allowing light emitted from the first light-emitting device 100-1, the second light-emitting device 100-2, the third light-emitting device 100-3, the fourth light-emitting device 100-4, and the fifth light-emitting device 100-5 to be guided by the light guide member 220a, the distribution of light existing from the light guide member 220a can be controlled.

### (Second Example)

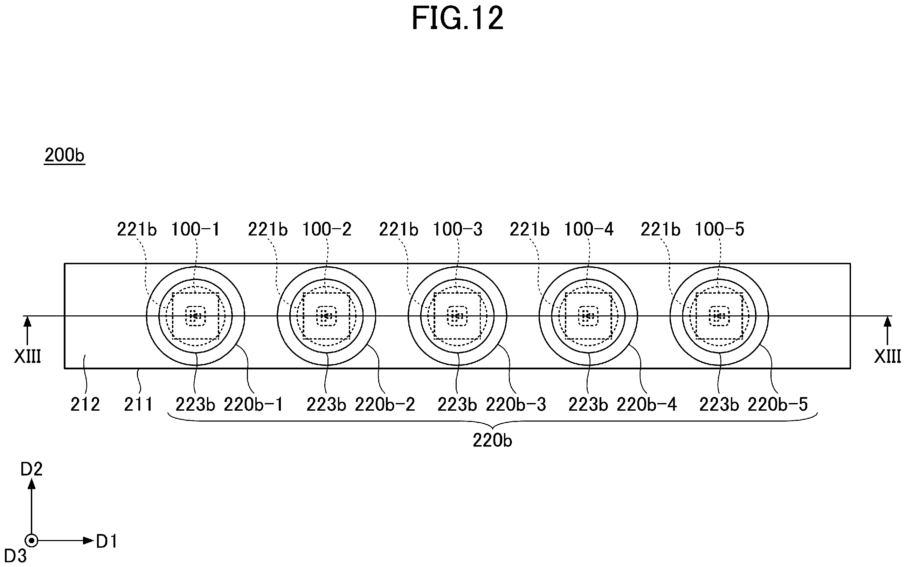

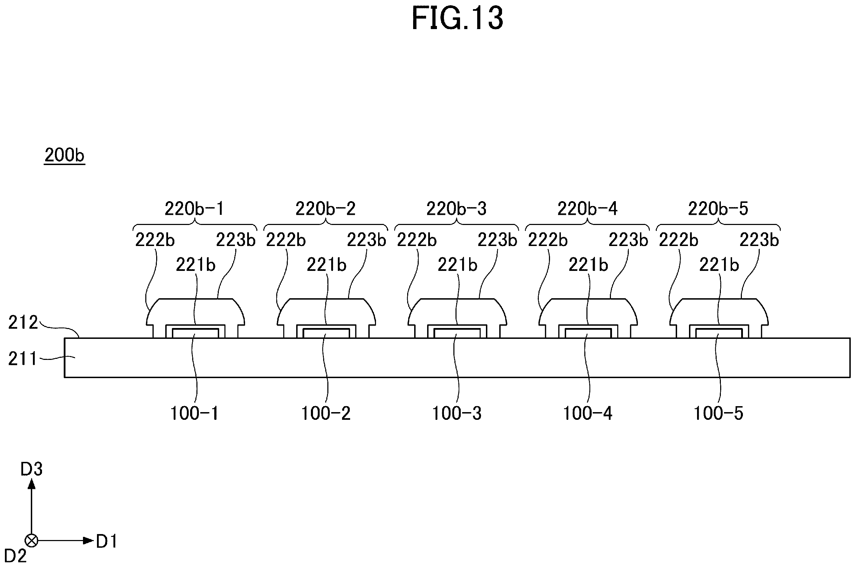

FIG. 12 is a schematic top view of a light-emitting unit 200b according to a second example of the sixth embodiment. FIG. 13 is a schematic cross-sectional view taken through line XIII-XIII of FIG. 12. In the top view of FIG. 12, there may be a case in which some components corresponding to those in the cross-sectional view of FIG. 13 are not illustrated to avoid excessive complication of the drawings.

The light-emitting unit 200b includes a substrate 211, a first light-emitting device 100-1, a second light-emitting device 100-2, a third light-emitting device 100-3, a fourth light-emitting device 100-4, a fifth light-emitting device 100-5, and a light guide member 220b. The light-emitting unit 200b is a light-emitting unit used as a backlight of a liquid crystal display panel, an organic electroluminescence (EL) display panel, or the like.

In the second example illustrated in FIG. 11, the first light-emitting device 100-1, the second light-emitting device 100-2, the third light-emitting device 100-3, the fourth light-emitting device 100-4, and the fifth light-emitting device 100-5 are disposed on an upper surface 212 of the substrate 211 and are arranged side by side in the first direction D1. Any of the light-emitting device 100, the light-emitting device 100a, the light-emitting device 100b, and the light-emitting device 100c can be applied to the first light-emitting device 100-1, the second light-emitting device 100-2, the third light-emitting device 100-3, the fourth light-emitting device 100-4, and the fifth light-emitting device 100-5.

The light guide member 220b includes a first light guide member 220b-1, a second light guide member 220b-2, a third light guide member 220b-3, a fourth light guide member 220b-4, and a fifth light guide member 220b-5.

The first light guide member 220b-1 is disposed above the first light-emitting device 100-1. The first light guide member 220b-1 is a member configured to allow light emitted from the first light-emitting device 100-1 to enter the inside of the first light guide member 220b-1, guide the light through the inside of the first light guide member 220b-1, and then exit the light from the inside of the first light guide member 220b-1 to the outside.

The second light guide member 220b-2 is disposed above the second light-emitting device 100-2. The second light guide member 220b-2 is a member configured to allow light emitted from the second light-emitting device 100-2 to enter the inside of the second light guide member 220b-2, guide the light through the inside of the second light guide member 220b-2, and then exit the light from the inside of the second light guide member 220b-2 to the outside.

The third light guide member 220b-3 is disposed above the third light-emitting device 100-3. The third light guide member 220b-3 is a member configured to allow light emitted from the third light-emitting device 100-3 to enter the inside of the third light guide member 220b-3, guide the light through the inside of the third light guide member 220b-3, and then exit the light from the inside of the third light guide member 220b-3 to the outside.

The fourth light guide member 220b-4 is disposed above the fourth light-emitting device 100-4. The fourth light guide member 220b-4 is a member configured to allow light emitted from the fourth light-emitting device 100-4 to enter the inside of the fourth light guide member 220b-4, guide the light through the inside of the fourth light guide member 220b-4, and then exit the light from the inside of the fourth light guide member 220b-4 to the outside.

The fifth light guide member 220b-5 is disposed above the fifth light-emitting device 100-5. The fifth light guide member 220b-5 is a member configured to allow light emitted from the fifth light-emitting device 100-5 to enter the inside of the fifth light guide member 220b-5, guide the light through the inside of the fifth light guide member 220b-5, and then exit the light from the inside of the fifth light guide member 220b-5 to the outside.

Each of the first light guide member 220b-1, the second light guide member 220b-2, the third light guide member 220b-3, the fourth light guide member 220b-4, and the fifth light guide member 220b-5 has a substantially circular outer shape in a top view, and has a transmittance of 60% or more with respect to light emitted from a corresponding light-emitting device 100. Further, each of the first light guide member 220b-1, the second light guide member 220b-2, the third light guide member 220b-3, the fourth light guide member 220b-4, and the fifth light guide member 220b-5 includes a light incident portion 221b, a first light exiting portion 222b, and a second light exiting portion 223b.

The light incident portion 221b is a substantially flat portion through which light from the light-emitting device 100 passes when entering the inside of the light guide member 220b. The light incident portion 221b has a substantially circular outer shape in a top view.

The first light exiting portion 222b is a curved portion through which a portion of light, emitted from the light-emitting device 100 and transmitted through the inside of the light guide member 220b, passes when exiting from the light guide member 220b. The first light exiting portion 222b has a substantially circular annular shape in a top view.

The second light exiting portion 223b is a substantially flat portion through which a portion of light, emitted from the light-emitting device 100 and transmitted through the inside of the light guide member 220b, passes when exiting from the light guide member 220b. The second light exiting portion 223b has a substantially circular outer shape in a top view.

In the light-emitting unit 200b, by allowing light emitted from the first light-emitting device 100-1, the second light-emitting device 100-2, the third light-emitting device 100-3, the fourth light-emitting device 100-4, and the fifth light-emitting device 100-5 to be guided by the light guide member 220b, the distribution of light existing from the light guide member 220b can be controlled.

The light guide members included in the light-emitting units according to the sixth embodiment are not limited to the light guide member 220a according to the first example and the light guide member 220b according to the second example. Each of the light guide members included in the light-emitting units according to the sixth embodiment may be, for example, one or more convex lenses, one or more concave lenses, one or more meniscus lenses, one or more Fresnel lenses, one or more diffraction lenses, one or more cylindrical lenses, or a combination of any of these lenses.

Although embodiments have been described in detail above, the above-described embodiments are non-limiting examples, and various modifications and substitutions can be made to the above-described embodiments without departing from the scope described in the claims.

The numbers such as ordinal numbers and quantities used in the description of the embodiments are all exemplified to specifically describe the techniques of the present disclosure, and the present disclosure is not limited to the exemplified numbers. In addition, the connection relationship between the components is illustrated for specifically describing the techniques of the present disclosure, and the connection relationship for implementing the functions of the present disclosure is not limited thereto.

The sizes of the light-emitting devices and the light-emitting units according to the present disclosure can be reduced. Thus, the light-emitting devices and the light-emitting units according to the present disclosure can each be suitably used as, for example, a light-emitting device for the interior of a vehicle such as an automobile. However, the light-emitting devices and the light-emitting units according to the present disclosure are not necessarily used for the interior of a vehicle, and can be used in various applications.

According to one embodiment of the present disclosure, a light-emitting device that is reduced in size can be provided.

### DESCRIPTION OF THE REFERENCE NUMERALS

1 support
101 first surface
11 first electrically-conductive part
111 first portion
112 second portion
113 third portion
12 second electrically-conductive part
13 third electrically-conductive part
2 light-emitting element
21 first light-emitting element
210 geometric center of first light-emitting element
22 second light-emitting element
220 geometric center of second light-emitting element
23 third light-emitting element
3 integrated circuit
30 outer lateral surface of integrated circuit
31 first outer edge
32 second outer edge
33 third outer edge
34 fourth outer edge
35, 36 corner
4 first wire
5 second wire
6 via
6c1 first via
6c2 second via
6c3 third via
7 first reflective member
70 outer lateral surface of first reflective member
71 opening
8 second reflective member
9 cover member
10 second cover member
51 to 60 electrically-conductive part
100, 100a, 100b light-emitting device
100-1 first light-emitting device
100-2 second light-emitting device
100-3 third light-emitting device
100-4 fourth light-emitting device
100-5 fifth light-emitting device
200, 200a, 200b light-emitting unit
211 substrate
212 upper surface
220a, 220b light guide member
220a-1 first light guide part
220a-2 second light guide part
220a-3 third light guide part
220a-4 fourth light guide part
220a-5 fifth light guide part
220b-1 first light guide member
220b-2 second light guide member
220b-3 third light guide member
220b-4 fourth light guide member
220b-5 fifth light guide member
221a, 221b light incident portion
222a first reflective portion
222b first light exiting portion
223a second reflective portion
223b second light exiting portion
224 light exiting part
a connection part
a51 connection part where second wire is connected to first electrically-conductive part
CH1 first element height
CH2 second element height
D1 first direction
D2 second direction
D3 third direction
e1 minimum interval between integrated circuit and via in second direction
e2 minimum interval between connection part and integrated circuit
e3 minimum interval between second light-emitting element and integrated circuit in second direction
e4 minimum interval between first light-emitting element and integrated circuit in second direction
L1 maximum length of integrated circuit in first direction
L2 maximum length of integrated circuit in second direction
L3 maximum length of first portion in first direction
L4 maximum length of second portion in first direction
L5 maximum length of opening in first direction
TH11 first height
TH12 second height
TH13 third height

## Claims

1. A light-emitting device comprising:
a support;
a first electrically-conductive part, a second electrically-conductive part, and a third electrically-conductive part disposed apart from one another on the support;
a first light-emitting element disposed on the first electrically-conductive part; and
an integrated circuit electrically connected to the first light-emitting element, wherein:
at least a portion of the first electrically-conductive part is located between the second electrically-conductive part and the third electrically-conductive part in a first direction,
the integrated circuit and the first light-emitting element are arranged side by side in a second direction orthogonal to the first direction, and
a maximum length of the integrated circuit in the second direction is smaller than a maximum length of the integrated circuit in the first direction.

2. The light-emitting device according to claim 1, wherein the integrated circuit is located on the first electrically-conductive part.

3. The light-emitting device according to claim 2, wherein:
the first electrically-conductive part comprises a first portion including a region overlapping the first light-emitting element,
the first electrically-conductive part comprises a second portion including a region overlapping the integrated circuit,
a maximum length of the first portion of the first electrically-conductive part in the first direction is smaller than a maximum length of the second portion of the first electrically-conductive part in the first direction.

4. The light-emitting device according to any one of claims 1 to 3, further comprising:
a plurality of first wires connected to the integrated circuit, wherein:
the integrated circuit has a first outer edge facing the first light-emitting element in a top view, a second outer edge located opposite to the first outer edge in the top view, a third outer edge connected to each of the first outer edge and the second outer edge in the top view, and a fourth outer edge located opposite to the third outer edge in the top view, and
the plurality of first wires are located apart from the second outer edge in the top view.

5. The light-emitting device according to claim 4, wherein a quantity of first wires overlapping the first outer edge in the top view is greater than a sum of a quantity of first wires overlapping the third outer edge in the top view and a quantity of first wires overlapping the fourth outer edge in the top view.

6. The light-emitting device according to claim 4, wherein:
the plurality of first wires include a second wire that connects the integrated circuit and the first electrically-conductive part,
the first electrically-conductive part comprises a portion located between the first light-emitting element and the integrated circuit in the second direction, and
the second wire is connected to said portion of the first electrically-conductive part.

7. The light-emitting device according to claim 6, wherein:
the support comprises a via connected to the first electrically-conductive part, and
the via is located between the first light-emitting element and the integrated circuit in the second direction.

8. The light-emitting device according to claim 7, wherein a minimum distance between the integrated circuit and the via in the second direction is smaller than a minimum distance between the integrated circuit and a connection part connecting the second wire to the first electrically-conductive part in the second direction.

9. The light-emitting device according to any one of claims 1 to 8, further comprising:
a second light-emitting element; and
a third light-emitting element, wherein:
a peak emission wavelength of the first light-emitting element is 430 nm or more and 480 nm or less,
a peak emission wavelength of the second light-emitting element is 500 nm or more and 580 nm or less, and
a peak emission wavelength of the third light-emitting element is 600 nm or more and 780 nm or less.

10. The light-emitting device according to claim 9, wherein a minimum distance between the second light-emitting element and the integrated circuit in the second direction is greater than a minimum distance between the first light-emitting element and the integrated circuit in the second direction.

11. The light-emitting device according to claim 7, further comprising:
a first reflective member surrounding the first light-emitting element in the top view, wherein:
the first reflective member covers at least a portion of each of the first outer edge, the third outer edge, and the fourth outer edge of the integrated circuit.

12. The light-emitting device according to claim 11, wherein a maximum length of an opening defined by lower ends of one or more inner lateral surfaces of the first reflective member in the first direction is smaller than the maximum length of the integrated circuit in the first direction.

13. The light-emitting device according to claim 11 or 12, wherein:
an outer edge of the integrated circuit has a rectangular shape in the top view,
the first reflective member covers two corners of the integrated circuit located closer to the first light-emitting element but does not cover two corners of the integrated circuit located on an opposite side from the first light-emitting element.

14. The light-emitting device according to any of claims 11 to 13, further comprising:
a cover member configured to cover an outer lateral surface of each of the first reflective member and the integrated circuit in the top view.

15. A light-emitting unit comprising:
a plurality of light-emitting devices of any one of claims 1 to 14, wherein:
the plurality of light-emitting devices are arranged side by side in the first direction.

16. The light-emitting unit according to claim 15, wherein:
the second electrically-conductive part is connected to an input terminal configured to input an electrical signal from an adjacent light-emitting device, and
the third electrically-conductive part is connected to an output terminal configured to output an electrical signal to the adjacent light-emitting device.

17. The light-emitting unit according to claim 15 or 16, wherein:
the support of each light-emitting device comprises:
a fourth electrically-conductive part located on one side of the integrated circuit in the first direction, and
a fifth electrically-conductive part located on another side of the integrated circuit in the first direction.
